# EUROPEAN PATENT SPECIFICATION

(11) **EP 3 758 072 B1**
(45) Date of publication and mention of the grant of the patent: **26.08.2026**
(21) Application number: 20168452.9
(22) Date of filing: 07.04.2020
(51) Int. Cl.: H10F 10/142, H10F 77/124, H10F 77/42, H10F 77/80

(54) **SOLAR CELL DESIGN OPTIMIZED FOR PERFORMANCE AT HIGH RADIATION DOSES**
FÜR BETRIEB BEI HOHEN STRAHLENDOSEN OPTIMIERTES SOLARZELLENDESIGN
CONCEPTION DE CELLULE SOLAIRE OPTIMISÉE POUR DES PERFORMANCES À DES DOSES DE RAYONNEMENT ÉLEVÉES

(30) Priority: 25.06.2019 US 201916452083
(43) Date of publication of application: 30.12.2020
(73) Proprietor: The Boeing Company, Arlington, VA 22202 (US)
(72) Inventor: Chiu, Philip T., Chicago, IL 60606-1596 (US); Fetzer, Christopher M., Chicago, IL 60606-1596 (US)
(74) Representative: Witte, Weller & Partner Patentanwälte mbB

(56) References cited:
- CN-A- 104 617 168
- SHVARTS M Z ET AL: "Radiation resistant AlGaAs/GaAs concentrator solar cells with internal Bragg reflector", SOLAR ENERGY MATERIALS AND SOLAR CELLS, ELSEVIER SCIENCE PUBLISHERS, AMSTERDAM, NL, vol. 68, no. 1, April 2001 (2001-04-01), pages 105 - 122, XP004226971, ISSN: 0927-0248, DOI: 10.1016/S0927-0248(00)00349-4
- MELLOR A ET AL: "Interstitial light-trapping design for multi-junction solar cells", SOLAR ENERGY MATERIALS AND SOLAR CELLS, ELSEVIER SCIENCE PUBLISHERS, AMSTERDAM, NL, vol. 159, 20 September 2016 (2016-09-20), pages 212 - 218, XP029788572, ISSN: 0927-0248, DOI: 10.1016/J.SOLMAT.2016.09.005
- ZHANG LEI ET AL: "Investigation on high-efficiency Ga0.51In0.49P/In0.01Ga0.99As/Ge triple-junction solar cells for space applications", AIP ADVANCES, AMERICAN INSTITUTE OF PHYSICS, 2 HUNTINGTON QUADRANGLE, MELVILLE, NY 11747, vol. 7, no. 12, 14 December 2017 (2017-12-14), XP012224547, DOI: 10.1063/1.5006865
- POLLY STEPHEN J ET AL: "Radiation Effects in Thinned GaAs Photovoltaics Incorporating DBRs for Improved Radiation Tolerance of Multijunctions", 2019 IEEE 46TH PHOTOVOLTAIC SPECIALISTS CONFERENCE (PVSC), IEEE, 16 June 2019 (2019-06-16), pages 2818 - 2821, XP033706428, DOI: 10.1109/PVSC40753.2019.8980875
- EMELYANOV V M ET AL: "Multijunction GaInP/GaInAs/Ge solar cells with Bragg reflectors", SEMICONDUCTORS, NAUKA/INTERPERIODICA, MO, vol. 44, no. 12, 30 December 2010 (2010-12-30), pages 1600 - 1605, XP019855566, ISSN: 1090-6479, DOI: 10.1134/S1063782610120122
- SKACHKOV A F: "Optimization of the structure of a GaInP/GaAs/Ge triple-junction solar cell with an Al0.1Ga0.9As/Al0.8Ga0.2As integrated bragg reflector", OPTOELECTRONICS, INSTRUMENTATION AND DATA PROCESSING, PLEIADES PUBLISHING, MOSCOW, vol. 50, no. 4, 24 September 2014 (2014-09-24), pages 423 - 427, XP035397266, ISSN: 8756-6990, [retrieved on 20140924], DOI: 10.3103/S8756699014040165
- ANDREEV V. M. ET AL: "Radiation Degradation of Multijunction III-V Solar Cells and Prediction of their Lifetime", PROCEEDINGS OF THE 27TH EUROPEAN PHOTOVOLTAIC SOLAR ENERGY CONFERENCE, 25 September 2012 (2012-09-25) - 28 September 2012 (2012-09-28), pages 169 - 174, XP040633711, ISBN: 978-3-936338-28-7

## Description

### BACKGROUND

### 1. Field.

The disclosure is related generally to a solar cell design optimized for performance at high radiation doses.

### 2. Background.

Until recently, space satellites operated in geosynchronous (GEO) orbits with total effective radiation dose of about 1e15 e-/cm². Over the past few years, missions have diversified to include those middle earth orbits (MEO) with far higher effective radiation doses that are an order of magnitude higher than that of GEO. Therefore, solar cell performance in high radiation space environments is becoming increasingly critical.

There have been previous methods to solve this problem. One such method is described in U.S. Patent No. 9,252,313, issued February 2, 2016, to Matthias Meusel et al., entitled "Monolithic Multiple Solar Cells," and assigned to Azur Space Solar Power GmbH (hereinafter referred to as the '313 patent).

The '313 patent specifies the use of a semiconductor mirror disposed between two partial cells, with the thickness of the partial cell above the mirror cut in half by using the mirror, without drastically reducing the absorption of the partial cell. However, the design of the '313 patent falls off in performance quickly after high radiation doses of about 1e15 e-/cm² or greater.

The paper "Radiation resistant AIGaAs/GaAs concentrator solar cells with internal Bragg reflector" by SHVARTS M Z ET AL, published in SOLAR ENERGY MATERIALS & SOLAR CELLS, vol. 68, no. 1, April 2001, p. 105-122 (XP004226971), in accordance to its abstract, states that the problem of increasing efficiency, reliability and radiation resistance of solar cells based on AlGaAs/GaAs heterostructures can be solved by using an internal Bragg reflector. The Bragg reflector as a back surface reflector and as a back surface potential barrier which allows to conserve the high photosensitivity in the long- and middle-wavelength parts of the spectrum after electron and proton irradiation. The effect of base doping and base thickness on the radiation resistance of AlGaAs/GaAs solar cells with the internal Bragg reflector has been investigated. Concentrator solar cells efficiency and related parameters before and after 3 MeV electron irradiation at the fluence up to 3 x 1015cm⁻² are represented. A base doping level of 1 x 10¹⁵ cm⁻³ and base thickness in the range 1.1-1.6 µm give an EOL AMO efficiency of 15.8% (BOL-22%) at 30 Suns concentration after exposure to 1 x 10¹⁵ cm⁻² electron fluence. This EOL efficiency is among the highest reported for GaAs single-junction concentrator cells under AMO conditions. Making the base doping level lower and the base thinner allows retaining a j_{EOL} / j_{BOL} ratio of 0.96 upon exposure up to 3 x 10¹⁵ e/cm² 3 MeV electron fluence. These results are additionally supported by the modeling calculations of the relative damage coefficient.

The paper "Interstitial light-trapping design for multi-junction solar cells" by MELLOR A ET AL, published in SOLAR ENERGY MATERIALS & SOLAR CELLS, vol. 159, 20 September 2016, p. 212-218 (XP029788572), in accordance to its abstract, states a light-trapping design capable of significantly enhancing the photon absorption in any subcell of a multi-junction solar cell. The design works by coupling incident light into waveguide modes in one of the subcells via a diffraction grating, and preventing these modes from leaking into lower subcells via a low-index layer and a distributed Bragg reflector, which together form an omnidirectional mirror. This allows the thickness of the target subcell to be reduced without compromising photon absorption, which improves carrier collection, and therefore photocurrent. The paper focuses on using the composite structure to improve the radiation hardness of a InGaP/Ga(In)As/Ge space solar cell. In this context, it is shown via simulation that the Ga(ln)As middle-cell thickness can be reduced from 3500 to 700 nm, whilst maintaining strong photon absorption, and that this leads to a significantly improved end-of-life photocurrent in the Ga(In)As middle cell. However, the design can in general be applied to a wide range of multi-junction solar cell types. They discuss the principles of operation of the design, as well as possible methods of its fabrication and integration into multi-junction solar cells.

The paper "Investigation on high-efficiency Ga0.51 In0.49P/ In0.01Ga0.99As/Ge triple-junction solar cells for space applications" by ZHANG LEI ET AL, published in AIP ADVANCES, vol. 7, no. 12, 14 December 2017 (XP012224547), in accordance with its abstract, states that Gao_{0.51} Ino_{0.49} P/In_{0.01} Ga_{0.99} As/Ge triple-junction solar cells for space applications were grown on 4 inch Ge substrates by metal organic chemical vapor deposition methods. The triple-junction solar cells were obtained by optimizing the subcell structure, showing a high open-circuit voltage of 2.77 V and a high conversion efficiency of 31 % with 30.15 cm2 area under the AMO spectrum at 25 °C. In addition, the In_{0.01} Ga_{0.99} As middle subcell structure was focused by optimizing in order to improve the anti radiation ability of triple-junction solar cells, and the remaining factor of conversion efficiency for middle subcell structure was enhanced from 84% to 92%. Finally, the remaining factor of external quantum efficiency for triple-junction solar cells was increased from 80% to 85.5%.

The paper "Radiation Effects in Thinned GaAs Photovoltaics Incorporating DBRs for Improved Radiation Tolerance of Multijunctions" by POLLY STEPHEN J ET AL, published in IEEE 46TH PHOTOVOLTAIC SPECIALISTS CONFERENCE (PVSC),16 June 2019, p. 2818-2821 (XP033706428), in accordance with its abstract, states that radiation tolerance of a triple junction solar cell can be improved by thinning the GaAs middle junction and maintaining power conversion efficiency through the use of a distributed Bragg reflector. Simulations using Sentaurus RSoft show that current density lost through reduction of the GaAs base thickness can be recovered by increasing the optical path length through the device using photonic structures such as a distributed Bragg reflector (DBR). In this paper, the simulation is further compared to experiment focusing on the GaAs middle cell, where prior to growing the diode a conductive DBR is grown epitaxially using MOCVD. Internal and external quantum efficiency, as well as performance under 1-siin illumination, is presented showing nearly complete recovery of performance to optically-thick conditions, while using half the thickness of GaAs absorber. These devices were then exposed to 1 MeV electrons with total doses of 2 x 10¹⁴ , 5 x 10¹⁴ , and 1 x 10¹⁵ cm⁻². Post-radiation experimental results show improved J_{SC} remaining factor, and absolute J_{SC} , for the optically thin device incorporating a DBR. This allows an improvement of 0.36 mA/cm² at a fluence of 1 x 10¹⁵ cm⁻² over the optically thick control. This result was incorporated into a Ge-based triple junction simulation and predicts a 0.24% absolute efficiency improvement at 1 x 10¹⁵ cm⁻² 1 MeV e⁻ fluence.

The paper "Multijunction GalnP/GalnAs/Ge solar cells with Bragg reflectors" by EMELYANOV V M ET AL, published in SEMICONDUCTORS, vol. 44, no. 12, 30 December 2010, p.1600-1605 (XP019855566), in accordance with its abstract, states that effect of subcell parameters on the efficiency of GaInP/Ga(In)As/Ge tandem solar cells irradiated with 1-MeV electrons at fluences of up to 3 x 10¹⁵ cm⁻² has been theoretically studied. The optimal thicknesses of GalnP and GalnAs subcells, which provide the best photocurrent matching at various irradiation doses in solar cells with and without built-in Bragg reflectors, were determined. The dependences of the photoconverter efficiency on the fluence of 1-MeV electrons and on the time of residence in the geostationary orbit were calculated for structures optimized to the beginning and end of their service lives. It is shown that the optimization of the subcell heterostructures for a rated irradiation dose and the introduction of Bragg reflectors into the structure provide a 5% overall increase in efficiency for solar cells operating in the orbit compared with unoptimized cells having no Bragg reflector.

The document CN 104 617 168 A states, in accordance with its abstract, a radiation-proof three-junction cascade gallium arsenide solar cell. The radiation-proof three-junction cascade gallium arsenide solar cell is such that a contact layer is arranged on a top cell; a first tunnel junction is arranged between the top cell and a medium cell; a second tunnel junction, at least one layer of distributed Bragg reflectors, a buffering layer and a coring layer are sequentially arranged between the medium cell and a bottom cell; a substrate is arranged below the bottom cell. According to the radiation-proof three-junction cascade gallium arsenide solar cell, the thickness of a GaInAs base area of the GaInAs medium cell is adjusted to be 1.4 to 2 microns to solve the problem of collection due to the reduction of a current carrier diffusion length caused by radiation, and therefore, the radiation resistance can be improved; meanwhile, at least one layer of distributed Bragg reflectors is arranged between the GaInAs medium cell and the Ge bottom cell, so that a light path route of the spectrum corresponding to the GaInAs medium cell, in the GaInAs medium cell can be improved, the short-current density can be increased, and relatively high conversion efficiency can be remained at the end period of the work; after the test equivalent to the total radiation of all high-energy particles on a geostationary satellite on the track in 15 years, the reduction rate of the conversion efficiency is only half that of the traditional structural solar cell.

Thus, there is a need for solar cell designs optimized for performance at high radiation doses.

### SUMMARY

To overcome the limitations described above, and to overcome other limitations that will become apparent upon reading and understanding the present specification, the present invention describes a solar cell as defined in claim 1, a method of fabricating as defined in claim 9, and a method of generating a current as defined in claim 10. Although the claimed invention is only defined by the claims, the below embodiments, examples, and aspects are present for aiding in understanding the background and advantages of the claimed invention.

### DRAWINGS

Referring now to the drawings in which like reference numbers represent corresponding parts throughout:
FIGS. 1A and 1B are layer schematics of triple junction solar cells, wherein FIG. 1A is a baseline solar cell and FIG. 1B is a new solar cell.
FIG. 2 is a graph of internal quantum efficiency (IQE) vs. Wavelength (nm) for the baseline and new solar cells.
FIG. 3 shows four experimental splits for a comparison of LIV (light-current-voltage) data, including Voc (open current voltage), Jsc (short circuit current), Eff (solar cell efficiency at a maximum power point), and FF (fill factor) between the baseline and new solar cells.
FIG. 4 is a graph of power retention (NPmp) vs. 1 MeV e- dose (e-/cm2) (electron fluence) for the baseline and new solar cells.
FIG. 5 is a graph of end-of-life (EOL) efficiency (%) vs. 1 MeV e- dose (e-/cm2) (electron fluence) for the baseline and new solar cells.
FIG. 6A illustrates a method of fabricating a solar cell, solar cell panel and/or satellite.
FIG. 6B illustrates a resulting satellite having a solar cell panel comprised of solar cells.
FIG. 7 is an illustration of the solar cell panel in the form of a functional block diagram.

### DETAILED DESCRIPTION

In the following description, reference is made to the accompanying drawings which form a part hereof, and in which is shown by way of illustration a specific example in which the disclosure may be practiced. It is to be understood that other examples may be utilized and structural changes may be made without departing from the scope of the present disclosure.

### Overview

The power retention of a standard triple junction (3J) space solar cell following exposure to space radiation is most greatly affected by the retention of the GaAs middle cell (i.e., middle sub-cell). This disclosure significantly improves on the power retention of the middle sub-cell by reducing the thickness of the base of the middle sub-cell to less than that required to fully absorb light and lowering the doping of the base of the middle sub-cell.

The base of the middle sub-cell has a thickness of 2.1 to 2.3 µm; and most preferably, the base of the middle sub-cell has a thickness of 2.1 µm.

The base of the middle sub-cell is p-type doped at 1e14 cm⁻³ to 1e16 cm⁻³.

A reflector, such as a distributed Bragg reflector (DBR), is inserted behind the middle sub-cell to compensate for the reduced thickness of the middle sub-cell base and to maximize the current of the middle sub-cell. The reflectance is centered at a wavelength of 870 nm.

Experimentally, beginning-of-life (BOL) solar cell efficiencies at 32% have been demonstrated using this disclosure that are 4% relative better than the current industry standard. Moreover, the end-of-life (EOL) power of the solar cell at high electron fluences of about 1e15 e-/cm² to 1e16 e-/cm² using this disclosure exceeds the previous state-of-the-art solar cell by 12% relative.

### Device

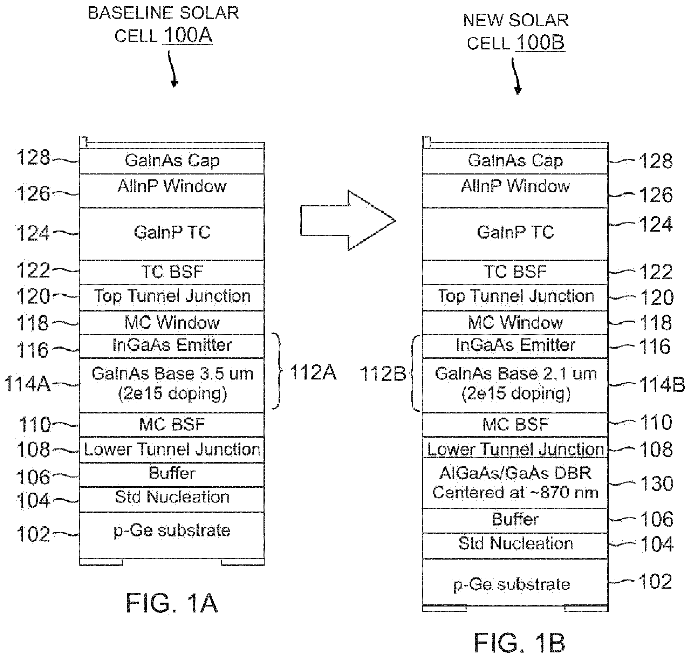

FIGS. 1A and 1B are layer schematics, each showing a cross-section of a device comprising baseline and new III-V 3J solar cells 100A, 100B, respectively, and describing both a method of fabricating the device and a method of generating a current using the device.

FIG. 1A shows the baseline III-V 3J solar cell 100A. The solar cell 100A includes a p-type doped germanium (p-Ge) substrate 102, upon which is deposited and/or fabricated a standard (std) nucleation layer 104, a buffer layer 106, a lower tunnel junction 108, a middle sub-cell (MC) back surface field (BSF) 110, a middle sub-cell 112A comprised of a base 114A and an emitter 116, wherein the base 114A is comprised of gallium indium arsenide (GaInAs) with p-type doping of about 1e14 cm⁻³ to 1e16 cm⁻³, and having a thickness of about 3.5 µm and the emitter 116 is comprised of indium gallium arsenide (InGaAs), an MC window 118, a top tunnel junction 120, a top sub-cell (TC) BSF 122, a top sub-cell 124 comprised of GaInP, a window 126 comprised of aluminum indium phosphide (AlInP), and a cap 128 comprised of GaInAs. The solar cell 100A may include other features not illustrated, such as an anti-reflection coating, and front and back metal contacts.

The baseline solar cell 100A has a fully-absorbing middle sub-cell 112A base 114A with a thickness of about 3.5 µm. The middle sub-cell 112A base 114A p-type doping is low at about 1e14 cm⁻³ to 1e16 cm⁻³, to increase the space charge region. The space charge region collects minority carriers regardless of reductions to the diffusion length of the middle sub-cell 112A caused by radiation damage. Such a layer design is optimized for radiation dose of about 1e15 e-/cm² or less.

FIG. 1B shows the new III-V 3J solar cell 100B according to this disclosure, wherein a reflector 130, i.e., a DBR 130 comprised of aluminum gallium arsenide (AlGaAs) and gallium arsenide (GaAs), is inserted behind the middle sub-cell 112B positioned between the buffer layer 106 and the lower tunnel junction 108, and the DBR 130 has a reflectance centered at a wavelength of about 870 nm. In addition, the middle sub-cell 112B includes a base 114B comprised of GaInAs with a p-type doping of about 1e14 cm⁻³ to 1e16 cm⁻³ that has a thickness of about 2.1 µm. Otherwise, the structure of 100B is the same as the structure of 100A.

The new solar cell 100B has two major changes from the baseline solar cell 100A, including a reduction in the middle sub-cell 112A base 114A of 3.5 µm to the middle sub-cell 112B base 114B thickness of 2.1 µm, and the addition of the DBR 130 with a center wavelength at 870 nm.

### Experimental Results

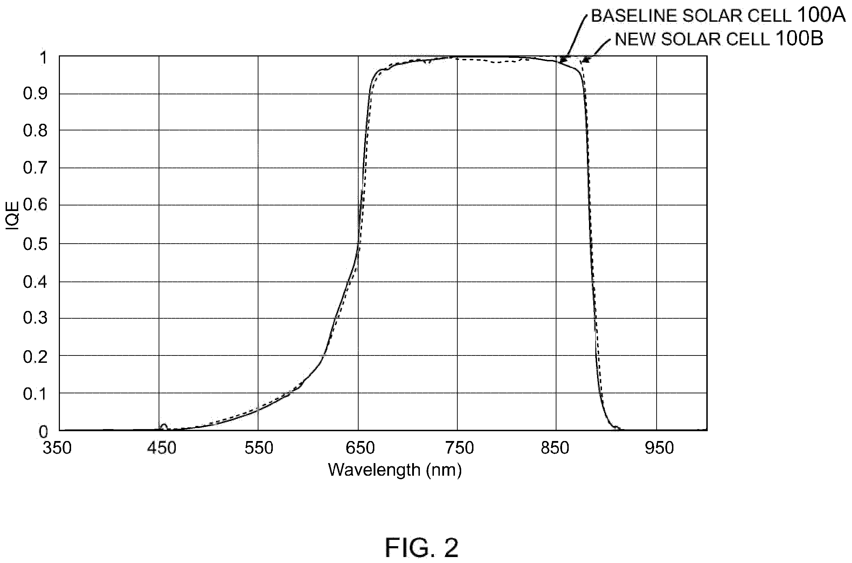

The use of the DBR 130 allows the middle sub-cell 112B base 114B to be thinned down to about 2.1 µm without compromising the current generated by the middle sub-cell 112B. This is demonstrated in FIG. 2, which is a graph that shows the internal quantum efficiency curves for the baseline solar cell 100A with a 3.5 µm thick middle sub-cell 112A base 114A, and the new solar cell 100B with a 2.1 µm thick middle sub-cell 112B base 114B.

Despite the fact that that the new solar cell 100B has a middle sub-cell 112B base 114B nearly half the thickness of the middle sub-cell 112A base 114A of the baseline solar cell 100A, the internal quantum efficiency (IQE) signatures are nearly identical and the integrated currents are the same within error. The thinner 2.1 µm middle sub-cell 112B base 114B for the new solar cell 100B also benefits the voltage of the new solar cell 100B. The thicker 3.5 µm middle sub-cell 112A base 114A has dark current near the back of the baseline solar cell 100A, where light intensities are low.

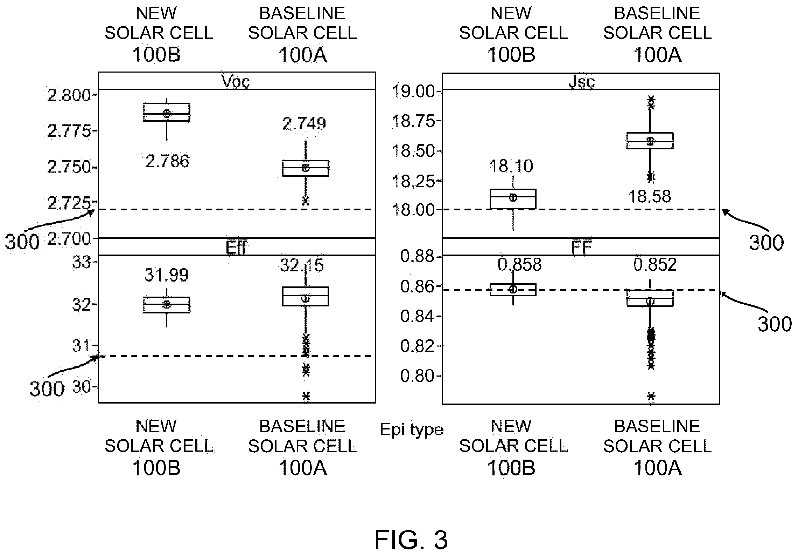

Partially as a consequence of the high middle sub-cell 112B current (from the DBR 130) and higher middle sub-cell 112B voltage (due to the middle sub-cell 112B base 114B being thinner), the new solar cell 100B has an exceptional BOL efficiency. The BOL LIV characteristics for the new solar cell 100B are summarized in FIG. 3.

FIG. 3 shows four experimental splits for a comparison of LIV (light-current-voltage) data, including Voc (open current voltage), Jsc (short circuit current), Eff (solar cell efficiency at a maximum power point), and FF (fill factor) between the baseline and new solar cells. The dotted lines 300 show the corresponding values for current state-of-the-art baseline solar cells 100A.

The new solar cell 100B is nearly 70 mV higher than the baseline solar cell 100A. The current of the new solar cell 100B matches that of the baseline solar cell 100A. Overall BOL efficiency for the new solar cell 100B is 4% higher than the baseline solar cell 100A.

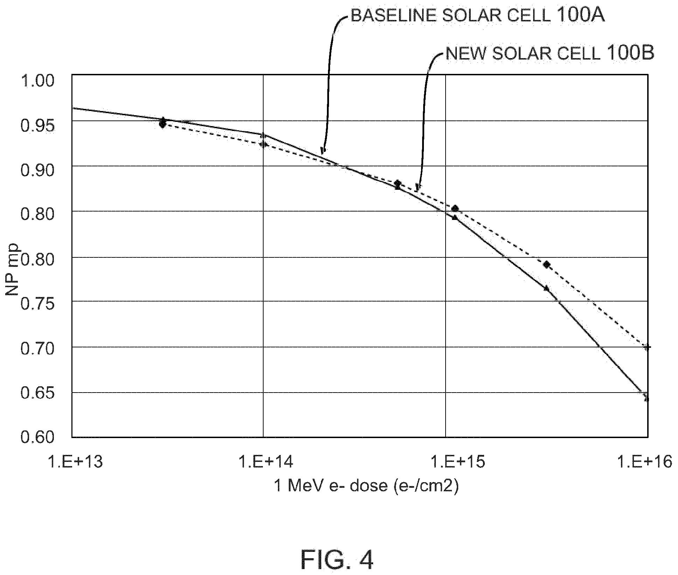

The low p-type doping (about 1e14 cm⁻³ to 1e16 cm⁻³) of the middle sub-cell 112B base 114B in the new solar cell 100B and the thinness (about 2.1 µm) of the middle sub-cell 112B base 114B in the new solar cell 100B has significant benefits in EOL performance, particularly at high radiation levels. A graph of power retention (NPmp) as a function of a 1 MeV electron radiation dose (e- dose) (e-/cm2) (electron fluence) for the baseline and new solar cells 100A, 100B is shown in FIG. 4. From FIG. 4, it is evident that the power retention of the new solar cell 100B is similar to the baseline solar cell 100A for the 1 MeV electron radiation dose from 0 to 5e14 e-/cm².

However, the 1 MeV electron radiation dose from about 1e15 e-/cm² to 1e16 e-/cm², the NPmp of the new solar cell 100B is clearly greater than the baseline solar cell 100A, with the difference increasing with increasing radiation dose. At the 1 MeV electron radiation doses of about 1e15 e-/cm² and 1e16 e-/cm², there is a 1% and 8% relative improvement in NPmp for the new solar cell 100B over the baseline solar cell 100A.

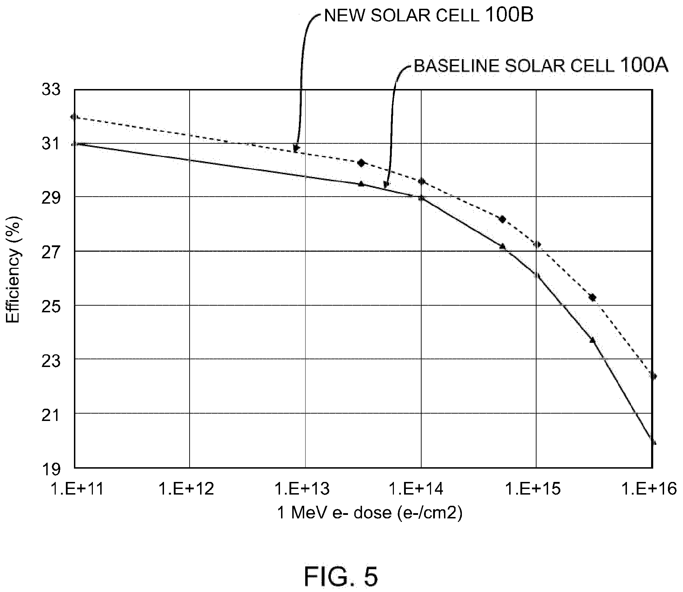

The combination of improved BOL efficiency and NPmp results in an improved EOL efficiency, where EOL efficiency = BOL efficiency x NPmp. A graph of EOL efficiency as a function of the 1 MeV electron radiation dose for the baseline and new solar cells 100A, 100B is shown FIG. 5.

From FIG. 5, it is clear that the EOL efficiency of the new solar cell 100B is greater than the baseline solar cell 100A at all radiation doses. At low doses, the difference in EOL efficiency is about 4%, due to the 4% advantage of the new solar cell 100B at BOL. Starting at the 1 MeV electron radiation dose of about 1e15 e-/cm², the difference in EOL efficiency starts to increase above about 4% due to the superior NPmp values for the new solar cell 100B relative to the baseline solar cell 100A. At the 1 MeV electron radiation dose of about 1e16 e-/cm², the difference in EOL efficiency is about 12%. This is a significant increase in EOL efficiency that is unmatched by other solar cells offered in the marketplace.

### Summary

This disclosure, is the first known solution that combines low p-type doping of a thin middle sub-cell 112B base 114B with a DBR 130 to optimize middle sub-cell 112B retention in high radiation environments. This results in at least two advantages.

First, the use of a middle sub-cell 112B base 114B having a thickness of about 2 to 3 µm, more preferably about 2.1 to 2.3 µm, and most preferably about 2.1 µm, combined with an effective DBR 130, in the new solar cell 100B, results in an effective absorption length equal to a fully absorbing middle sub-cell 112A base 114A having a thickness of about 3 to 3.5 µm, without a DBR, in the baseline solar cell 100A. In this way, the BOL current of the middle sub-cell 112B in the new solar cell 100B, and hence the BOL efficiency of the new solar cell 100B, is not compromised to improve EOL efficiency. Consequently, the new solar cell 100B is still able to achieve BOL efficiency levels of near 32% that are 4% relative above the current state-of-the-art baseline solar cell 100A.

Second, the relatively thinner middle sub-cell 112B base 114B in the new solar cell 100B, combined with the low p-type doping of the middle sub-cell 112B base 114B in the new solar cell 100B, results in power retention with a radiation dose of about 1e15 e-/cm₂ to 1e16 e-/cm₂ that is unmatched in the industry. As a result, power retention and EOL power for the new solar cell 100B solution is 12% better than the current state-of-the-art baseline solar cell 100A at these radiation doses.

The result of this disclosure is a new solar cell 100B design optimized for performance at high radiation doses that exhibits an EOL efficiency 12% better than present state-of-the-art baseline solar cell 100A designs after a MEO-like radiation dose of about 1e16 e-/cm².

### Alternatives and Modifications

The description set forth above has been presented for purposes of illustration and description, and is not intended to be exhaustive or limited to the examples described. Many alternatives and modifications may be used in place of the specific description set forth above.

For example, although this disclosure describes the widely adopted triple junction solar cell 100B, it could be broadened to cover any instance of a solar cell 100B comprising a single or multiple junction solar cell, e.g., single junction solar cells, double junction solar cells, or other multiple junction solar cells.

In another example, although the middle sub-cell 112B is described as comprising InGaAs and GaInAs other materials could also be used.

In yet another example, although this disclosure describes the middle sub-cell 112B, base 114B, and DBR 130 are described as comprising certain materials, alternatives may describe the middle sub-cell 112B, and base 114B, as consisting of, or consisting essentially of, these or other materials.

In yet another example, this disclosure is applicable to inverted metamorphic (IMM) devices in any sub-cell to enhance the radiation retention of the devices. Specifically, this disclosure may be applied to GaAs, GaInAs, AlGaAs, AlGaInAs, GaInAsSb, GaInAsN, GaInAsNSb, GaInAsSb, GaAsSb, GaPAsSb sub-cells within that architecture.

Typically, the sub-cells have an n-on-p configuration as is usual for a p-type Ge substrate, which means that the emitter of the sub-cell is n-type and the base is p-type. However, other examples may comprise a p-on-n configuration, wherein the emitter of the sub-cell is p-type and the base is n-type.

Similarly, although this disclosure describes the new solar cell 100B performing in a desired manner at a radiation dose of about 1e15 e-/cm² to 1e16 e-/cm², alternatives may describe the new solar cell 100B as performing in the desired manner at radiation doses greater than or less than the range of about 1e15 e-/cm² to 1e16 e-/cm².

### Aerospace Applications

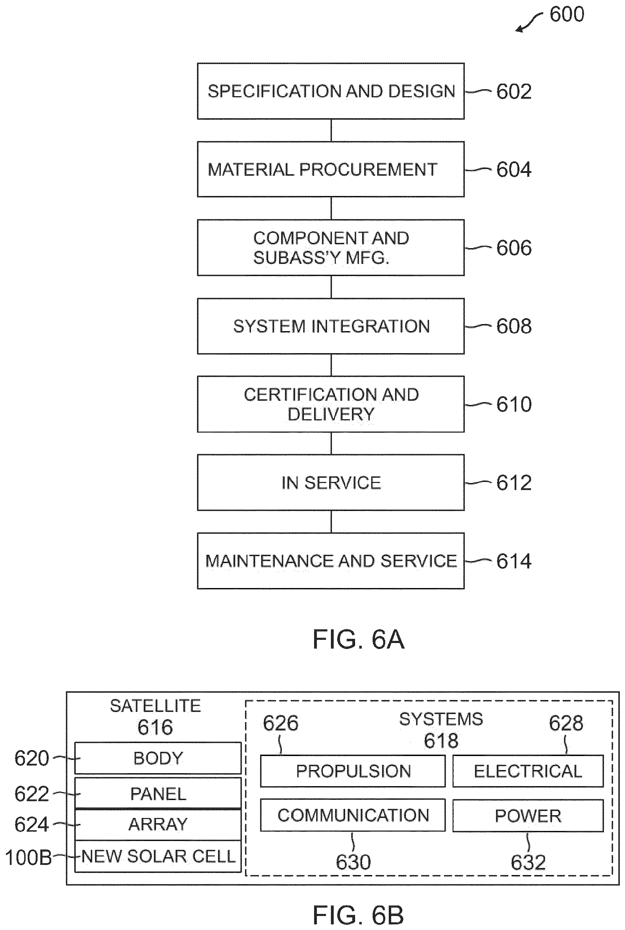

Examples of the disclosure may be described in the context of a method 600 of fabricating a solar cell, solar cell panel and/or aerospace vehicle such as a satellite, comprising steps 602-614, as shown in FIG. 6A, wherein the resulting satellite 616 comprised of various systems 618 and a body 620, including a panel 622 comprised of an array 624 of one or more new solar cells 100B is shown in FIG. 6B.

As illustrated in FIG. 6A, during pre-production, exemplary method 600 may include specification and design 602 of the satellite 616, and material procurement 604 for same. During production, component and subassembly manufacturing 606 and system integration 608 of the satellite 616 takes place, which include fabricating the satellite 616, panel 622, array 624 and new solar cells 100B. Thereafter, the satellite 616 may go through certification and delivery 610 in order to be placed in service 612. The satellite 616 may also be scheduled for maintenance and service 614 (which includes modification, reconfiguration, refurbishment, and so on), before being launched.

Each of the processes of method 600 may be performed or carried out by a system integrator, a third party, and/or an operator (e.g., a customer). For the purposes of this description, a system integrator may include without limitation any number of manufacturers and major-system subcontractors; a third party may include without limitation any number of venders, subcontractors, and suppliers; and an operator may be a satellite company, military entity, service organization, and so on.

As shown in FIG. 6B, the satellite 616 fabricated by exemplary method 600 may include various systems 618 and a body 620. Examples of the systems 618 included with the satellite 616 include, but are not limited to, one or more of a propulsion system 626, an electrical system 628, a communications system 630, and a power system 632. Any number of other systems also may be included.

### Functional Block Diagram

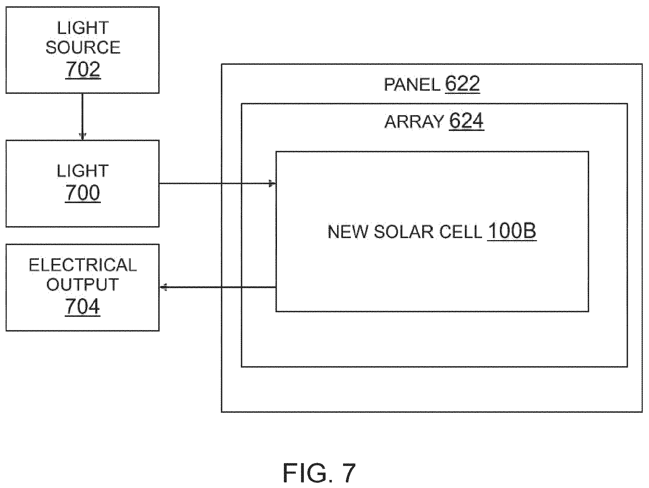

FIG. 7 is an illustration of the panel 622 in the form of a functional block diagram, according to one example. The panel 622 is comprised of the array 624, which is comprised of one or more of the new solar cells 100B individually attached to the panel 622. The solar cell 100B may comprise a single or multiple junction solar cell 100B, e.g., a single junction solar cell 100B, double junction solar cell 100B, or other multiple junction solar cell 100B. At least one of the new solar cells 100B includes a sub-cell 112B comprised of a base 114B and an emitter 116, the base 114B has a thickness of about 2 to 3 µm, the base 114B is p-type doped at about 1e14 cm⁻³ to 1e16 cm⁻³, and a DBR 130 is inserted behind the sub-cell 112B to maximize current generated by the sub-cell 112B. Each of the new solar cells 100B absorbs light 700 from a light source 702 and generates an electrical output 704 in response thereto.

Further, the disclosure comprises examples according to the following paragraphs:
There is disclosed a device, comprising: a solar cell optimized for performance at high radiation doses, wherein the solar cell includes: a sub-cell comprised of a base and an emitter; the base of the sub-cell has a thickness of about 2 to 3 µm; the base of the sub-cell is doped at about 1e14 cm⁻³ to 1e16 cm⁻³; and a reflector is inserted behind the sub-cell to maximize current generated by the sub-cell.

Preferably, the high radiation doses comprise radiation doses of about 1e15 e-/cm² to 1e16 e-/cm².

Preferably, the solar cell is a single junction or multiple junction solar cell.

Preferably, the reflector is a distributed Bragg reflector comprised of aluminum gallium arsenide (AlGaAs) and gallium arsenide (GaAs).

Preferably, the reflector is positioned between a buffer layer and a lower tunnel junction of the solar cell.

Preferably, the reflector has a reflectance centered at a wavelength of about 870 nm.

Preferably, the sub-cell is a middle sub-cell of the solar cell.

Preferably, the emitter of the sub-cell is comprised of indium gallium arsenide (InGaAs).

Preferably, the base of the sub-cell is comprised of gallium indium arsenide (GaInAs).

Preferably, the base of the sub-cell has a thickness of about 2.1 to 2.3 µm.

Preferably, the base of the sub-cell has a thickness of about 2.1 µm.

Preferably, the solar cell is optimized for performance at the high radiation doses as compared to a baseline solar cell having a thicker sub-cell base and no reflector.

Preferably, a power retention as a function of a 1 MeV electron radiation dose of the solar cell is similar to the baseline solar cell for the 1 MeV electron radiation dose from about 0 to 5e14 e-/cm².

Preferably, a power retention as a function of a 1 MeV electron radiation dose of the solar cell is greater than the baseline solar cell for the 1 MeV electron radiation dose from about 1e15 e-/cm² to 1e16 e-/cm².

Preferably, the beginning-of-life (BOL) efficiency of the solar cell is greater than the baseline solar cell at all radiation doses.

Preferably, an end-of-life (EOL) efficiency of the solar cell is greater than the baseline solar cell at all radiation doses.

Preferably, the device further conmprises a panel including the solar cell.

The device preferably further comprises a space vehicle including the panel.

Also, there is disclosed a method, comprising: fabricating a solar cell optimized for performance at high radiation doses, wherein the solar cell includes: a sub-cell comprised of a base and an emitter; the base of the sub-cell has a thickness of about 2 to 3 µm; the base of the sub-cell is doped at about 1e14 cm⁻³ to 1e16 cm⁻³; and a reflector is inserted behind the sub-cell to maximize current generated by the sub-cell.

Still further, there is disclosed a method, comprising: generating a current using a solar cell optimized for performance at high radiation doses, wherein the solar cell includes: a sub-cell comprised of a base and an emitter; the base of the sub-cell has a thickness of about 2 to 3 µm; the base of the sub-cell is doped at about 1e14 cm⁻³ to 1e16 cm⁻³; and a reflector is inserted behind the sub-cell to maximize current generated by the sub-cell.

## Claims

1. A triple junction (3J) solar cell (100B) optimized for performance at high radiation doses, wherein the high radiation doses comprise radiation doses of 1e15 e-/cm² to 1e16 e-/cm², wherein the triple junction (3J) solar cell (100B) includes in the following order:
a cap (128) comprised of gallium indium arsenide (GaInAs);
a window (126) comprised of aluminum indium phosphide (AlInP);
a top sub-cell (124) comprised of GaInP;
a top sub-cell (TC) back surface field (BSF) (122);
a top tunnel junction (120);
a middle sub-cell (MC) window (108);
a middle sub-cell (112B) comprised of a gallium indium arsenide (GaInAs) base (114B) and an indium gallium arsenide (InGaAs) emitter (116); the base (114B) of the middle sub-cell (112B) has a reduced thickness of 2.1 to 2.3 µm that is less than a thickness required to fully absorb light;
the base (114B) of the middle sub-cell (112B) is p-type doped at about 1e14 cm⁻³ to 1e16 cm⁻³;
a middle sub-cell (MC) back surface field (BSF) (110), wherein the gallium indium arsenide (GaInAs) base (114B) is positioned above the middle sub-cell (MC) back surface field (BSF) (110);
a lower tunnel junction (108);
a reflector (130) that has a reflectance centered at a wavelength of 870 nm to compensate for the reduced thickness of the middle sub-cell (112B), to capture a second pass of light through the sub-cell (112B), and to maximize current generated by the middle sub-cell (112B), wherein the reflector (130) is a distributed Bragg reflector (130) comprised of aluminum gallium arsenide (AlGaAs) and gallium arsenide (GaAs);
a buffer layer (106);
a standard (std) nucleation layer (104); and
a p-type doped germanium (p-Ge) substrate (102).

2. The triple junction (3J) solar cell (100B) of claim 1, wherein the triple junction (3J) solar cell (100B) is optimized for performance at the high radiation doses, wherein the reduced thickness does not compromise a current generated by the middle sub-cell as compared to a baseline solar cell (100A) having a thicker sub-cell (112A) base (114A) and no reflector (130).

3. The triple junction (3J) solar cell (100B) of claim 2, wherein a power retention as a function of a 1 MeV electron radiation dose of the triple junction (3J) solar cell (100B) is similar to the baseline solar cell (100A) for the 1 MeV electron radiation dose from about 0 to 5e14 e-/cm².

4. The triple junction (3J) solar cell (100B) of claim 2 or 3, wherein a power retention as a function of a 1 MeV electron radiation dose of the triple junction (3J) solar cell (100B) is greater than the baseline solar cell (100A) for the 1 MeV electron radiation dose from about 1e15 e-/cm² to 1e16 e-/cm².

5. The triple junction (3J) solar cell (100B) of claim 2, 3 or 4, wherein the beginning-of-life (BOL) efficiency of the triple junction (3J) solar cell (100B) is greater than the baseline solar cell (100A) at all radiation doses.

6. The triple junction (3J) solar cell (100B) of claim 2, 3, 4 or 5, wherein an end-of-life (EOL) efficiency of the triple junction (3J) solar cell (100B) is greater than the baseline solar cell (100A) at all radiation doses.

7. A panel (622) including the triple junction (3J) solar cell (100B) of any of claims 1-6.

8. A space vehicle (616) including the panel (622) of claim 7.

9. A method, comprising:
fabricating (600-614) a triple junction (3J) solar cell (100B) as defined in any of the claims 1 to 6.

10. A method, comprising:
generating (704) a current using a triple junction (3J) solar cell (100B) as defined in any of the claims 1 to 6.

## Patentansprüche

1. Dreifachübergangs-(3J-)Solarzelle (100B), die auf Leistung bei hohen Strahlungsdosen optimiert ist, wobei die hohen Strahlungsdosen Strahlungsdosen von 1e15 e-/cm2 bis 1e16 e-/cm2 aufweisen, wobei die Dreifachübergangs-(3J-)Solarzelle (100B) in der folgenden Reihenfolge umfasst:
eine Deckschicht (128), die aus Galliumindiumarsenid (GaInAs) aufgebaut ist;
ein Fenster (126), das aus Aluminiumindiumphosphid (AlInP) aufgebaut ist;
eine obere Subzelle (124), die aus GaInP aufgebaut ist;
ein Rückseitenfeld (BSF) (122) der oberen Subzelle (TC);
einen oberen Tunnelübergang (120);
ein Fenster (108) einer mittleren Subzelle (MC);
eine mittlere Subzelle (112B), die eine Basis (114B) aus Galliumindiumarsenid (GaInAs) und einen Emitter (116) aus Indiumgalliumarsenid (InGaAs) aufweist; wobei die Basis (114B) der mittleren Subzelle (112B) eine verringerte Dicke von 2,1 bis 2,3 µm aufweist, die geringer als eine Dicke ist, die für eine vollständige Lichtabsorption erforderlich ist;
wobei die Basis (114B) der mittleren Subzelle (112B) mit einer p-Typ-Dotierung von etwa 1*e*14 cm⁻³ bis 1*e*16 cm⁻³ dotiert ist;
ein Rückseitenfeld (BSF) (110) der mittleren Subzelle (MC), wobei die Basis (114B) aus Galliumindiumarsenid (GaInAs) oberhalb des Rückseitenfelds (BSF) (110) der mittleren Subzelle (MC) angeordnet ist;
einen unteren Tunnelübergang (108);
einen Reflektor (130), der eine auf eine Wellenlänge von etwa 870 nm zentrierte Reflexion aufweist, um die verringerte Dicke der mittleren Subzelle (112B) auszugleichen, um einen zweiten Lichtdurchgang durch die Subzelle (112B) zu erfassen und um einen durch die mittlere Subzelle (112B) erzeugten Strom zu maximieren, wobei der Reflektor (130) ein Bragg-Reflektor (130) ist, der aus Aluminiumgalliumarsenid (AlGaAs) und Galliumarsenid (GaAs) aufgebaut ist;
eine Pufferschicht (106);
eine Standard-(std-)Nukleationsschicht (104); und
ein p-Typ-dotiertes Germaniumsubstrat (p-Ge) (102).

2. Dreifachübergangs-(3J-)Solarzelle (100B) nach Anspruch 1, wobei die Dreifachübergangs-(3J-)Solarzelle (100B) auf Leistung bei den hohen Strahlungsdosen optimiert ist, wobei die verringerte Dicke einen durch die mittlere Subzelle (112B) erzeugten Strom im Vergleich zu einer Baseline-Solarzelle (100A) mit einer dickeren Basis (114A) der mittleren Subzelle (112A) und ohne Reflektor (130) nicht beeinträchtigt.

3. Dreifachübergangs-(3J-)Solarzelle (100B) nach Anspruch 2, wobei eine Leistungserhaltung als Funktion einer 1-MeV-Elektronenstrahlungsdosis der Dreifachübergangs-(3J-)Solarzelle (100B) ähnlich der Baseline-Solarzelle (100A) für die 1-MeV-Elektronenstrahlungsdosis von etwa 0 bis 5e14 e-/cm² ist.

4. Dreifachübergangs-(3J-)Solarzelle (100B) nach Anspruch 2 oder 3, wobei eine Leistungserhaltung als Funktion einer 1-MeV-Elektronenstrahlungsdosis der Dreifachübergangs-(3J-)Solarzelle (100B) größer als die Baseline-Solarzelle (100A) für die 1-MeV-Elektronenstrahlungsdosis von etwa 1e15 /cm² bis 1e16 e⁻/cm² ist.

5. Dreifachübergangs-(3J-)Solarzelle (100B) nach Anspruch 2, 3 oder 4, wobei ein Wirkungsgrad zu Beginn der Lebensdauer (BOL) der Dreifachübergangs-(3J-)Solarzelle (100B) größer als bei der Baseline-Solarzelle (100A) bei allen Strahlungsdosen ist.

6. Dreifachübergangs-(3J-)Solarzelle (100B) nach Anspruch 2, 3, 4 oder 5, wobei ein Wirkungsgrad am Ende der Lebensdauer (EOL) der Dreifachübergangs-(3J-)Solarzelle (100B) größer als bei der Baseline-Solarzelle (100A) bei allen Strahlungsdosen ist.

7. Paneel (622), das die Dreifachübergangs-(3J-)Solarzelle (100B) nach einem der Ansprüche 1 bis 6 umfasst.

8. Raumfahrzeug (616), das das Paneel (622) nach Anspruch 7 umfasst.

9. Verfahren, das aufweist:
Herstellen (600-614) einer Dreifachübergangs-(3J-)Solarzelle (100B), wie sie in einem der Ansprüche 1 bis 6 definiert ist.

10. Verfahren, das aufweist:
Erzeugen (704) eines Stroms unter Verwendung einer Dreifachübergangs-(3J-) Solarzelle (100B), wie sie in einem der Ansprüche 1 bis 6 definiert ist.

## Revendications

1. Cellule solaire à triple jonction (3J) (100B) optimisée pour des performances à des doses de rayonnement élevées, dans laquelle les doses de rayonnement élevées comprennent des doses de rayonnement de 1e15 e-/cm² à 1e16 e-/cm², dans laquelle la cellule solaire à triple jonction (3J) (100B) comporte, dans l'ordre suivant :
une couche de recouvrement (128) constituée d'arséniure de gallium et d'indium (GalnAs) ;
une fenêtre (126) constituée de phosphure d'aluminium et d'indium (AlInP) ;
une sous-cellule supérieure (124) constituée de GaInP ;
un champ de surface arrière (BSF) de sous-cellule supérieure (TC) (122) ;
une jonction tunnel supérieure (120) ;
une fenêtre de sous-cellule intermédiaire (MC) (108) ;
une sous-cellule intermédiaire (112B) constituée d'une base en arséniure de gallium et d'indium (GalnAs) (114B) et d'un émetteur en arséniure d'indium et de gallium (InGaAs) (116) ; la base (114B) de la sous-cellule centrale (112B) a une épaisseur réduite de 2,1 à 2,3 µm qui est inférieure à une épaisseur requise pour absorber complètement la lumière ;
la base (114B) de la sous-cellule intermédiaire (112B) est dopée de type p à environ 1e14 cm⁻³ à 1e16 cm⁻³ ;
un champ de surface arrière (BSF) de sous-cellule intermédiaire (MC) (110), dans laquelle la base en arséniure de gallium et d'indium (GaInAs) (114B) est positionnée au-dessus du champ de surface arrière (BSF) de sous-cellule intermédiaire (MC) (110) ;
une jonction tunnel inférieure (108) ;
un réflecteur (130) qui a une réflectance centrée sur une longueur d'onde de 870 nm pour compenser l'épaisseur réduite de la sous-cellule centrale (112B), pour capturer un second passage de lumière à travers la sous-cellule (112B), et pour maximiser un courant généré par la sous-cellule intermédiaire (112B), dans laquelle le réflecteur (130) est un réflecteur de Bragg distribué (130) constitué d'arséniure d'aluminium et de gallium (AlGaAs) et d'arséniure de gallium (GaAs) ;
une couche tampon (106) ;
une couche de nucléation standard (std) (104) ; et
un substrat en germanium dopé de type p (p-Ge) (102).

2. Cellule solaire à triple jonction (3J) (100B) selon la revendication 1, dans laquelle la cellule solaire à triple jonction (3J) (100B) est optimisée pour des performances aux doses de rayonnement élevées, dans laquelle l'épaisseur réduite ne compromet pas un courant généré par la sous-cellule intermédiaire par rapport à une cellule solaire de référence (100A) ayant une base (114A) de sous-cellule (112A) plus épaisse et aucun réflecteur (130).

3. Cellule solaire à triple jonction (3J) (100B) selon la revendication 2, dans laquelle une rétention de puissance en fonction d'une dose de rayonnement d'électrons de 1 MeV de la cellule solaire à triple jonction (3J) (100B) est similaire à la cellule solaire de référence (100A) pour la dose de rayonnement d'électrons de 1 MeV d'environ 0 à 5e14 e-/cm².

4. Cellule solaire à triple jonction (3J) (100B) selon la revendication 2 ou 3, dans laquelle une rétention de puissance en fonction d'une dose de rayonnement d'électrons de 1 MeV de la cellule solaire à triple jonction (3J) (100B) est supérieure à la cellule solaire de référence (100A) pour la dose de rayonnement électronique de 1 MeV d'environ 1e15 e-/cm² à 1e16 e-/cm².

5. Cellule solaire à triple jonction (3J) (100B) selon la revendication 2, 3 ou 4, dans laquelle l'efficacité en début de vie (BOL) de la cellule solaire à triple jonction (3J) (100B) est supérieure à la cellule solaire de référence (100A) à toutes les doses de rayonnement.

6. Cellule solaire à triple jonction (3J) (100B) selon la revendication 2, 3, 4 ou 5, dans laquelle une rendement de fin de vie (EOL) de la cellule solaire à triple jonction (3J) (100B) est supérieur à la cellule solaire de référence (100A) à toutes les doses de rayonnement.

7. Panneau (622) comportant la cellule solaire à triple jonction (3J) (100B) selon l'une quelconque des revendications 1 à 6.

8. Véhicule spatial (616) comportant le panneau (622) selon la revendication 7.

9. Procédé, comprenant :
la fabrication (600-614) d'une cellule solaire à triple jonction (3J) (100B) selon l'une quelconque des revendications 1 à 6.

10. Procédé, comprenant :
la génération (704) d'un courant à l'aide d'une cellule solaire à triple jonction (3J) (100B) selon l'une quelconque des revendications 1 à 6.
